(19)

**Europäisches Patentamt**
**European Patent Office**
**Office européen des brevets**

(11) **EP 4 561 271 A1**

(12) **EUROPEAN PATENT APPLICATION**

(43) Date of publication:
**28.05.2025 Bulletin 2025/22**

(51) International Patent Classification (IPC):
**H05K 1/02** (2006.01)          **H05K 3/00** (2006.01)
**H05K 1/11** (2006.01)

(21) Application number: **24214762.7**

(22) Date of filing: **22.11.2024**

(52) Cooperative Patent Classification (CPC):
**H05K 1/0251; H05K 3/0094;** H05K 1/113;
H05K 3/0047; H05K 2201/09481; H05K 2201/0959;
H05K 2203/0139; H05K 2203/0207; H05K 2203/085

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **22.11.2023   US 202363602273 P**

(71) Applicant: **Arista Networks, Inc.**
**Santa Clara, CA 95054 (US)**

(72) Inventors:
• **Weaver, James Alden**
  **Santa Clara, CA 95054 (US)**
• **Chan, Jason Edward**
  **Santa Clara, CA 95054 (US)**
• **Espinoza, Jason**
  **Santa Clara, CA 95054 (US)**
• **Ittigimath, Virupakshaiah**
  **Santa Clara, CA 95054 (US)**

(74) Representative: **Hoffmann Eitle**
**Patent- und Rechtsanwälte PartmbB**
**Arabellastraße 30**
**81925 München (DE)**

(54) **CONTROLLING DEPTH OF PENETRATION OF BACKDRILL CAVITY FILLING BY ADJUSTING INITIAL AMBIENT PRESSURE**

(57) A method for controlled filling of a backdrill cavity in an unused portion of a via to a desired penetration depth of the backdrill cavity can begin with setting a starting gas pressure in the backdrill cavity to a back-filling fixture chamber pressure in a filling pressure chamber. The back-filling fixture chamber pressure is selected based on a desired penetration depth h of a non-conductive filling material within the backdrill cavity, given a fill application pressure to be applied to the backdrill cavity. Then, the non-conductive filling material is applied with the fill application pressure to the backdrill cavity until a final gas pressure in the backdrill cavity equals to the fill application pressure and the backdrill cavity has a final gas volume of $\frac{\pi}{4} d^2 (H - h)$, where H represents a backdrill depth and d represents a backdrill diameter of the backdrill cavity.

FIG. 5

EP 4 561 271 A1

## Description

CROSS-REFERENCE TO RELATED APPLICATION(S)

This is a conversion of, and claims a benefit of priority under 35 U.S.C. § 119(e) from, U.S. Provisional Application No. 63/602,273, filed November 22, 2023, entitled "CONTROLLING DEPTH OF PENETRATION OF BACKDRILL CAVITY FILLING BY ADJUSTING INITIAL AMBIENT PRESSURE," the entire content of which is fully incorporated by reference herein for all purposes.

TECHNICAL FIELD

This disclosure relates generally to printed circuit board (PCB) fabrication. More particularly, this disclosure relates to PCB backdrilling. Even more particularly, this disclosure relates to a method for controlling the depth of penetration of backdrill cavity filling by adjusting the initial ambient pressure.

BACKGROUND OF THE RELATED ART

A PCB is a rigid structure that is used to mechanically support and electrically connect electronic components using conductive pathways, tracks, or signal traces etched from copper sheets laminated onto a non-conductive substrate. Today, various challenges exist in PCB manufacturing. Retaining signal integrity is one of these challenges.
Generally, a signal propagates from the top surface of a PCB (typically from a component) to a trace in the PCB. Some of the incident signal is transmitted to the trace. However, the presence of a via stub causes some of the signal to be reflected back to its source. This reflection interferes with the original signal and weakens the transmitted signal and, therefore, degrades the signal quality. The problem intensifies as stub length increases.
In view of the foregoing, there is a need for innovations and improvements in PCB fabrication.

BRIEF DESCRIPTION OF DRAWINGS

The drawings accompanying and forming part of this specification are included to depict certain aspects of the disclosure. It should be noted that the features illustrated in the drawings are not necessarily drawn to scale. A more complete understanding of the disclosure and the advantages thereof may be acquired by referring to the following description, taken in conjunction with the accompanying drawings in which like reference numbers indicate like features.

FIG. 1 shows an example incident signal traveling from the top side of a PCB through a via to a trace, with some of the signal reflected back to the top surface of the PCB.

FIG. 2 shows an example via with two stubs.

FIG. 3 shows an example via that has been back-drilled, creating a backdrill cavity.

FIG. 4 shows an example PCB having ground and power planes which attract electric field lines from the back-drilled end of the via stub, creating a coupling between the via and the planes.

FIG. 5 illustrates the dynamics of backdrill cavity filling, according to some embodiments disclosed herein.

FIG. 6A shows an example of a backdrill cavity filling process, according to some embodiments disclosed herein.

FIG. 6B shows the completion of the backdrill cavity filling process of FIG. 6A, according to some embodiments disclosed herein.

FIG. 7 shows the electrical effect of the backdrill fill material on the magnitude of the return loss, according to some embodiments disclosed herein.

FIG. 8 is a flowchart that illustrates a backdrill filling process according to some embodiments disclosed herein.

DETAILED DESCRIPTION

Specific embodiments will now be described with reference to the accompanying figures (FIGS). The figures and the following description describe certain embodiments by way of illustration only. One skilled in the art will readily recognize from the following description that alternative embodiments of the structures and methods illustrated herein may be employed without departing from the principles described herein. It is noted that wherever practicable similar or like reference numbers may be used in the figures and may indicate similar or like functionality.

Backdrilling is a technique that is used to remove the unused portion (stub) of a via with a slightly larger sized drill bit, leaving a cavity in the PCB. Leaving the backdrill cavity unfilled allows debris to enter the cavity and can cause reliability problems over time. To this end, existing backdrill filling operations completely fill this backdrill cavity using an ambient vacuum or minimally fill it using an ambient pressure of one atmosphere. However, pressing the backfill in at atmospheric pressure leads to shallow fills that can pop out during reflow soldering.

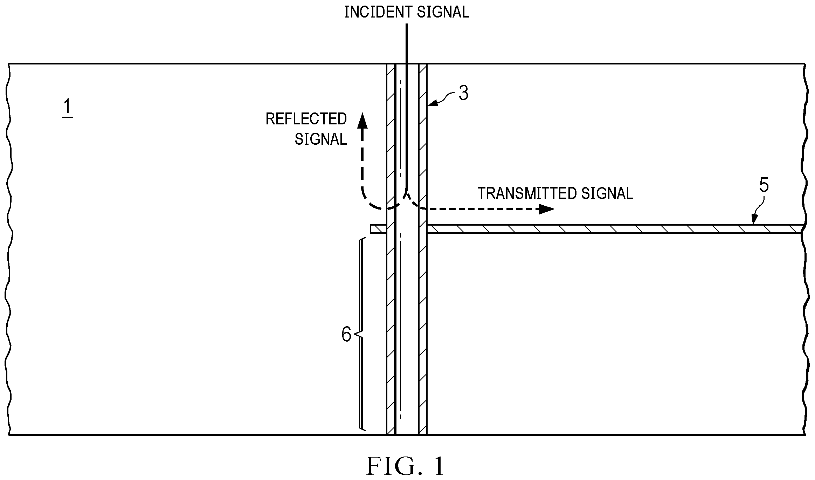

FIG. 1 shows an incident signal traveling from the top surface of a PCB (1) through a copper plated drilled hole, known as a via (3), to a copper signal trace (5). Traces like these distribute the signal through the PCB. In the example of FIG. 1, the signal propagates from the top surface of the PCB (typically from a component of the PCB) to the trace in the PCB. The part of the via beyond where the connection is made to the signal trace is the via stub (6).

As illustrated in FIG. 1, some of the incident signal is transmitted to the trace. However, the presence of the stub causes some of the signal to be reflected back, thereby reducing the strength of the transmitted signal and degrading signal quality. The problem intensifies as stub length increases.

While FIG. 1 shows the incident signal traveling from the top side of the PCB to the signal trace, a similar problem exists if the signal travels from the bottom side of the PCB. In this case, the stub is the section of the via above the signal trace.

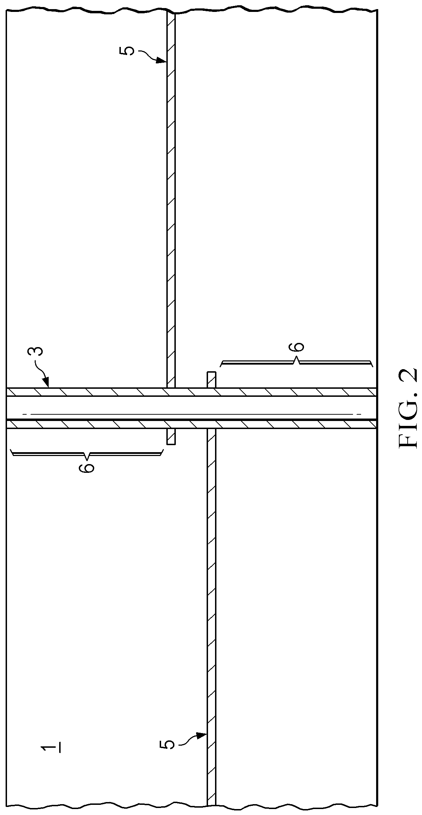

In some cases, a via may have two stubs. This is illustrated in FIG. 2. Here, the via (3) connects two signal traces at different depths in different layers in the PCB (5) together. There are now two stubs (6), one above the upper trace and one below the lower trace. Signal quality is degraded with increasing length of either, or both, of these stubs. In the situation depicted in FIG. 2, the incident signal arrives from one of the traces (left or right) and travels into the other trace (right or left). This situation arises when a via is used to change signal layers, so there is no attachment to either via end. However, since there is a stub attached to each trace, reflections are caused by both stubs.

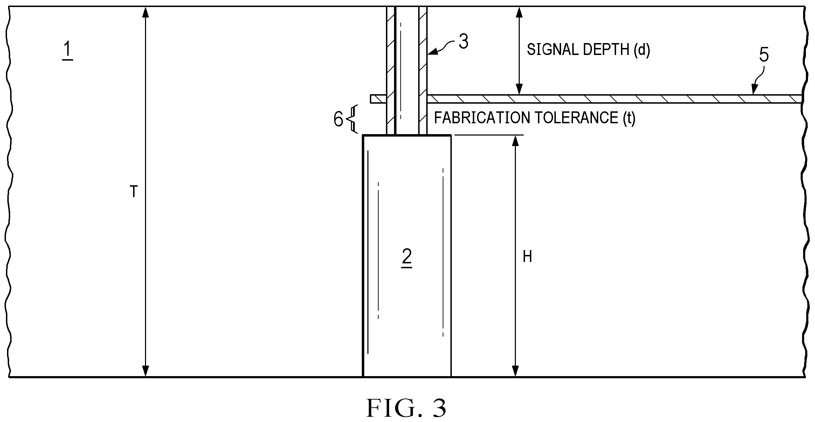

To attenuate the negative effects of these stubs, a technique known as backdrilling is used. FIG. 3 shows a via (3) that has been back-drilled. A drill having a larger diameter than the via (not shown) is centered on the via and used to create a backdrill cavity (2) having a depth (H). This backdrilling shortens the via stub (6) to a desired length that separates the copper signal trace (5) and the backdrill cavity. Fabrication tolerances prevent a zero-length back-drilled stub, lest the via to signal trace connection be broken. With backdrilling, the signal quality can be significantly improved. Accordingly, backdrilling is commonly used for high-performance PCBs.

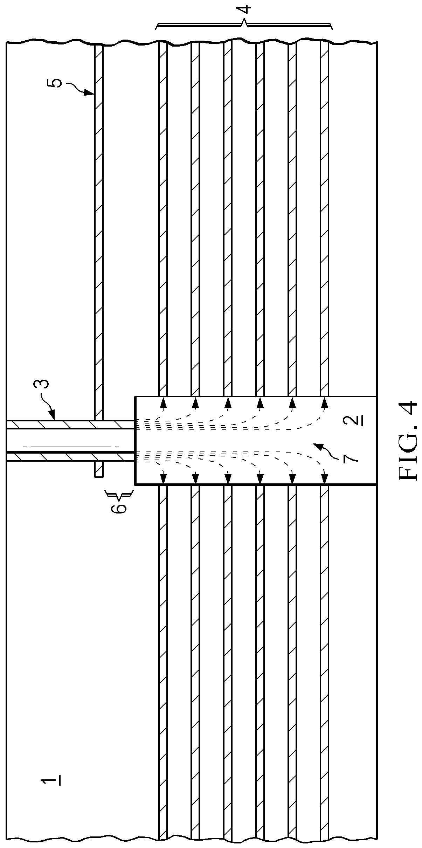

Unfortunately, backdrilling is not without problems. FIG. 4 shows a PCB (1) having ground and power planes (4). These planes attract electric field (as indicated by the electric field lines (7)) from the back-drilled end of the via stub, creating a coupling between the via and the planes. This coupling increases the effective electrical length of the via. If the cavity (2) is left open, it is filled with air. Because air has a low dielectric constant of 1.00059 at room temperature (25 °C, or 77 °F), the lengthening effect is minimized. However, to prevent infiltration of debris (e.g., metal shavings, dust particles, etc.), the backdrill cavity is usually filled with epoxy, or similar material, which has a much larger dielectric constant (e.g., 3-4 times larger) than the dielectric constant of air. This means that the resulting effective lengthening can be unacceptably large, particularly at high signal rates, (e.g., 200 gigabits per second).

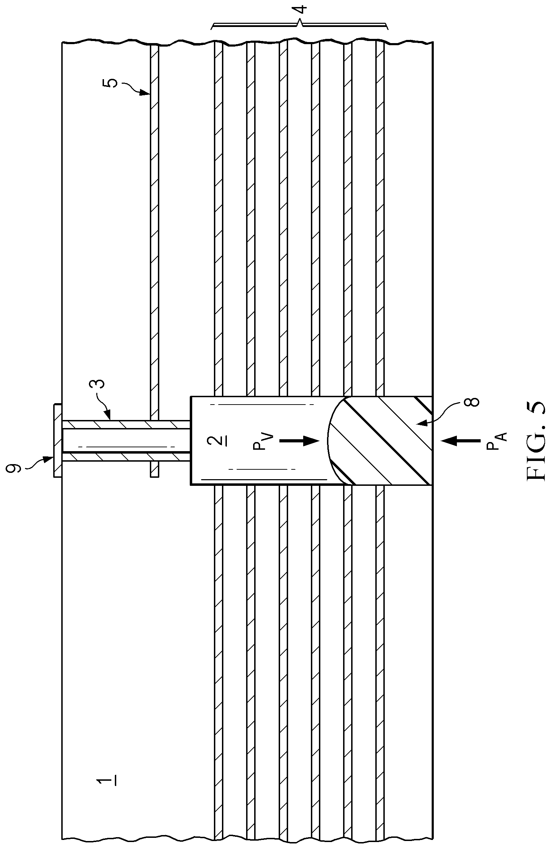

To this end, embodiments disclosed herein specifically control the ambient pressure to control the depth of penetration of the backfill material applied to the cavity in the backdrill cavity filling process. Before describing the embodiments, the dynamics of backdrill cavity filling are described below with reference to FIG. 5.

As illustrated in FIG. 5, a backfill material (8) is applied to a backdrill cavity (2) side of a PCB (1) and mechanically driven into the cavity under pressure $P_A$. As a non-limiting example, a squeegee can be used to apply a non-conductive filling material with a dielectric constant greater than air, such as an epoxy, to the backdrill cavity. The non-conductive filling material can initially be in liquid form and harden as it cures over time or with the application of a curing process.

Vias can be closed at the end opposite of the backdrill cavity by a plated-over pad or other means, such as plugging the via hole with a solder mask. With the plated-over pad, the pad is made of a plated copper and is not removable once applied. The pad can be soldered to by a component on the surface of the PCB. In the example of FIG. 5, the via (3) is closed by a plated-over pad (9) at the end of the via (3) that is opposite of the backdrill cavity (2). In this way, as the backfill material (8) fills the backdrill cavity (2), the pressure in the backdrill cavity (2), Pv, rises, creating an opposing force that stops further cavity filling.

To counter this effect, the PCB is placed in a pressure chamber and the air is evacuated. In such a case, Pv, remains zero (or near zero) throughout the filling process, yielding complete cavity filling. This complete filling is undesirable as it produces maximum effective electrical lengthening of the stub.

Disclosed embodiments are directed to partial filling of the backdrill cavity by specifically controlling the ambient pressure during the backdrill filling process which, in turn, controls the depth of penetration of the backfill material into the backdrill cavity. The section of the cavity that is not filled will have a low dielectric constant, while the filled section with the higher dielectric constant is furthest from the stub end. This results in a much lower increase in electrical stub length and better signal quality.

So long as the initial pressure in the pressure chamber, $P_{V-initial}$, is adjusted to yield the desired depth of penetration of the backfill, any means of closing the via, whether permanent or temporary, are compatible with the disclosed embodiments. Further, while the primary intended use is to keep the backfill at sufficient distance from the stub end (closest to the via) to minimize backfill effects, it may be possible, in some use cases, to deliberately use the effect of the backfill to tune the impedance or other characteristics of the via (3) by tuning the depth of backfill penetration.

In practice, the desired depth of penetration of the backfill may vary from implementation to implementation. This means that the actual initial pressure in the pressure chamber, $P_{V\_initial}$, may also vary from implementation to implementation. Below provides an example of how the initial pressure in the pressure chamber may be determined.

Constituting Equations

The initial chamber pressure can be approximated using the ideal gas law:

$$Pv = nRT$$

where P is the gas pressure, v is the gas volume, n is the number of moles of gas, R is the universal gas constant, and T is the gas temperature.

Given the large mass of a PCB, the small amount of gas contained in the backdrill hole and the slow rate of backdrill filling, it is reasonable to model the filling as an isothermal process, where the gas temperature and the number of moles of gas are constant. So then:

$$P_1 v_1 = P_2 v_2 \qquad \text{Equation (1)}$$

where P1 is the initial pressure at the beginning of the backdrill filling process, v1 is the initial volume of the backdrill, P2 is the final pressure after the backdrill filling process is completed, and v2 is the final volume of the backdrill remaining without fill after the filling process is completed.

Application to Filling

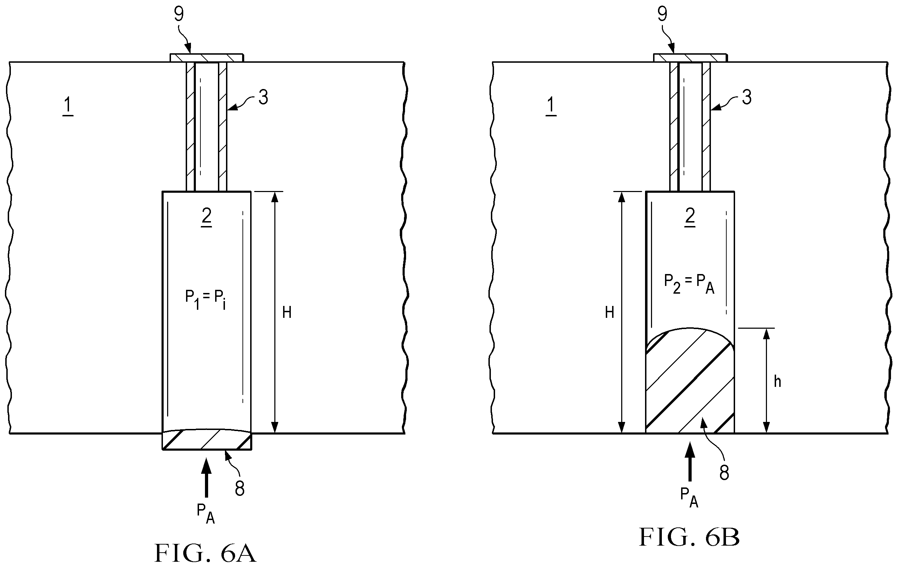

FIGS. 6A-6B together show an example of a backdrill cavity filling process, according to some embodiments disclosed herein. FIG. 6A depicts a situation at the instant the filling begins, with a starting gas pressure in the backdrill cavity, $P_1$, equals the back-filling fixture chamber pressure, $P_i$, and the gas volume is $\frac{\pi}{4} d^2 H$, where d is the backdrill diameter and $H$ is the backdrill depth.

The depth of the backdrill cavity, H, can vary from implementation to implementation as there can be many different cavity depths per board. The backdrill cavity filling process disclosed herein would apply to all of these implementations. H, however, can be affected by the signal depth, i.e., the distance that a signal travels from a surface of a PCB (top or bottom) to a copper trace (5) in the PCB, as illustrated in FIG. 3. For example, suppose the PCB has a thickness, T, and a signal originating from the top surface of the PCB travels a distance (i.e., a "gap"), g, to the copper trace (5). In this example, the maximum depth of the backdrill cavity, H, equals to T - (g + t), where t is the separation distance between the copper signal trace (5) and the bottom of the backdrill cavity, also referred to as a fabrication tolerance.

FIG. 6B shows that, at the completion of the filling process, the final gas pressure, $P_2$, equals the applied filling pressure, $P_A$, and the final gas volume is $\frac{\pi}{4} d^2 (H - h)$, where h is the penetration depth of the filling material. Like H, the penetration depth of the filling material, h, can vary from implementation to implementation and the backdrill cavity filling process disclosed herein would apply to all of these implementations. Deterministic factors that may affect h can include the maximum depth of the backdrill cavity, H, the filling material, the fill application pressure to be applied, $P_A$, etc.

For example, applying Equation (1) gives:

$$P_i \frac{\pi}{4} d^2 H = P_A \frac{\pi}{4} d^2 (H - h)$$

which gives the result that:

$$P_i = P_A \left(1 - \frac{h}{H}\right) \qquad\qquad \text{Equation (2)}$$

The initial filling chamber pressure, $P_i$, is the fill application pressure, $P_A$, scaled by one minus the filling fraction $\frac{h}{H}$. Thus, the initial filling chamber pressure can be chosen to give a desired fill depth of h, given the fill application pressure to be applied, $P_A$.

Electrical Effect of the Fill Material

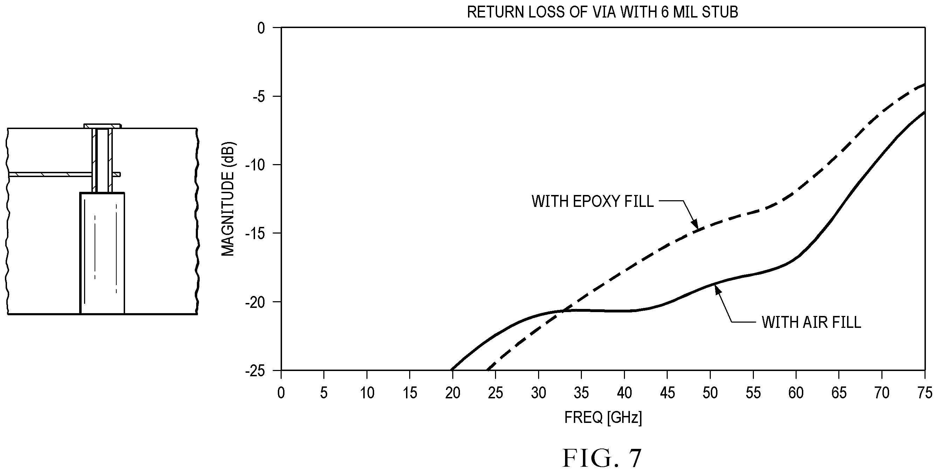

FIG. 7 shows the electrical effect of a backdrill fill material on the magnitude of the return loss, measured in decibels (dB) for an example 6 mil stub, according to some embodiments disclosed herein. As illustrated in the diagram shown on the left of FIG. 7, the backdrill cavity was completely filled, either with air or a non-conductive filling material such as an epoxy. In this example, the depth of the backdrill cavity H is 76.5 mils, and the return loss is the ratio of voltage signal reflected from the via-to-trace transition to voltage signal incident at the transition. The magnitude plotted in FIG. 7 is:

$$20 \left( \left| \frac{V_{reflected}}{V_{incident}} \right| \right)$$

For good link performance, this value should be very much less than one (i.e., negative dB values). A value of -15dB or less is desirable. The return loss for the epoxy filled backdrill rises above this value at a signal frequency of 48 GHz, whereas the return loss for the air filled backdrill rises above this value at a signal frequency of 66 GHz. This 18 GHz increase in frequency will enable better signal quality, particularly for the 200 Gbit/sec signal. The type of epoxy or other fill material used to fill the backdrill cavity can be selected based upon the dielectric constant of the material and its corresponding effect on the return loss.

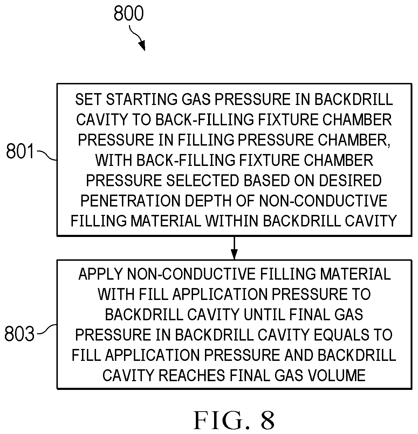

FIG. 8 is a flowchart that illustrates a backdrill filling process 800 for controlled filling of a backdrill cavity with a non-conductive material to a desired penetration depth h, according to some embodiments disclosed herein. The backdrill cavity is in an unused portion (stub) of a via connected to a signal trace in a printed circuit board. The backdrill cavity has a backdrill diameter d, a backdrill depth H, and an initial gas volume defined by $\frac{\pi}{4} d^2 H$. The printed circuit board has a top surface and a thickness T. A signal originating from the top surface of the printed circuit board travels a distance g to the signal trace. The backdrill depth H of the backdrill cavity has a maximum depth defined by T - (g + t), wherein t represents a separation distance between the signal trace and a bottom of the backdrill cavity.

In some embodiments, the backdrill filling process may begin with setting a starting gas pressure in the backdrill cavity to a back-filling fixture chamber pressure in a filling pressure chamber (801). The back-filling fixture chamber pressure is selected based on the desired penetration depth of the non-conductive filling material within the backdrill cavity, given a fill application pressure to be applied to the backdrill cavity.

Then, the non-conductive filling material is applied to the backdrill cavity under the fill application pressure until a final gas pressure in the backdrill cavity equals to the fill application pressure and the backdrill cavity has a final gas volume of $\frac{\pi}{4} d^2 (H - h)$ (803).

If the via has two stubs, one on each end of the via, the backdrill filling process described above can be applied to each respective stub for controlled filling of a backdrill cavity in the respective stub with a non-conductive material to a desired penetration depth. In one embodiment, the backdrill cavities in the stubs may be filled with the same non-conductive material or different non-conductive materials. In another embodiment, the desired penetration depth may be the same in back-filling the backdrill cavities in the stubs. In yet another embodiment, the backdrill cavities in the stubs may be backfilled to different desired penetration depths. In such a case, backdrill filling parameters, such as the starting gas pressure, the fill application pressure, and the final gas volume, would differ from one backdrill filling process to another. For instance, if different pressures are used, different lengths of time may correspondingly need to elapse for the non-conductive material to harden. Skilled artisans can appreciate that a curing process may need to be applied between backfilling the two stubs.

In this disclosure, specific embodiments have been described with reference to the accompanying figures. In the above description, numerous details are set forth as examples. It will be understood by those skilled in the art, and having the benefit of this Detailed Description, that one or more embodiments described herein may be practiced without these specific details and that numerous variations or modifications may be possible without departing from the scope of the embodiments. Certain details known to those of ordinary skill in the art may be omitted to avoid obscuring the description.

In the above description of the figures, any component described with regard to a figure, in various embodiments, may be equivalent to one or more like-named components shown and/or described with regard to any other figure. For brevity, descriptions of these components may not be repeated with regard to each figure. Thus, each and every embodiment of the components of each figure is incorporated by reference and assumed to be optionally present within every other figure having one or more like-named components. Additionally, in accordance with various embodiments described herein, any description of the components of a figure is to be interpreted as an optional embodiment, which may be implemented in addition to, in conjunction with, or in place of the embodiments described with regard to a corresponding like-named component in any other figure.

Throughout the application, ordinal numbers (*e.g.*, first, second, third, etc.) may be used as an adjective for an element (*i.e.*, any noun in the application). The use of ordinal numbers is not to imply or create any particular ordering of the elements nor to limit any element to being only a single element unless expressly disclosed, such as by the use of the terms "before", "after", "single", and other such terminology. Rather, the use of ordinal numbers is to distinguish between the elements. By way of an example, a first element is distinct from a second element, and the first element may encompass more than one element and succeed (or precede) the second element in an ordering of elements.

As used herein, the phrase operatively connected, or operative connection, means that there exists between elements/components/devices a direct or indirect connection that allows the elements to interact with one another in some way. For example, the phrase 'operatively connected' may refer to any direct (*e.g.*, wired directly between two devices or components) or indirect (*e.g.*, wired and/or wireless connections between any number of devices or components connecting the operatively connected devices) connection. Thus, any path through which information may travel may be considered an operative connection.

While embodiments described herein have been described with respect to a limited number of embodiments, those skilled in the art, having the benefit of this Detailed Description, will appreciate that other embodiments can be devised which do not depart from the scope of embodiments as disclosed herein. Accordingly, the scope of embodiments described herein should be limited only by the attached claims.

## Claims

1.  A method for controlling penetration depth of backdrill cavity filling in a printed circuit board having a via with a backdrill cavity, the method comprising:

    setting a gas pressure in the backdrill cavity, $P_i$, where $P_i$, is dependent on $P_A$, a fill application pressure to be applied to a fill material to at least partially fill the backdrill cavity; and
    applying the fill material with the fill application pressure $P_A$ to the backdrill cavity, wherein the fill material is non-conductive.

2.  The method according to claim 1, wherein $P_i$ is set to $P_A \left( 1 - \dfrac{h}{H} \right)$, wherein H is a depth of the backdrill cavity and wherein h is a final depth of the fill material in the backdrill cavity.

3.  The method according to claim 1 or claim 2, wherein the fill material comprises an epoxy.

4.  The method according to claim 3, further comprising curing the epoxy.

5.  The method according to any preceding claim, further comprising closing an end of the via that is on an opposite side of the backdrill cavity prior to applying the fill material with the fill application pressure to the backdrill cavity.

6.  A printed circuit board processed by a method comprising:

    setting a gas pressure in a backdrill cavity of a via in the printed circuit board to $P_i$, where $P_i$, is dependent on $P_A$, a fill application pressure to be applied to a fill material to at least partially fill the backdrill cavity; and
    applying the fill material with the fill application pressure $P_A$ to the backdrill cavity,
    wherein the fill material is non-conductive.

7.  The printed circuit board of claim 6, wherein $P_i$ is set to $P_A \left( 1 - \dfrac{h}{H} \right)$, wherein H is a depth of the backdrill cavity and wherein h is a final depth of the fill material in the backdrill cavity.

8. The printed circuit board of claim 6 or claim 7, wherein the fill material comprises an epoxy.

9. The printed circuit board of claim 8, wherein the epoxy cures over a period of time after being applied.

10. The printed circuit board of any of claims 6 to 9, wherein the via connects a first signal trace and a second signal trace at different depths in the printed circuit board, wherein the via has a first stub and a second stub, wherein the first stub is located above the first signal trace, wherein the second stub is located below the second signal trace, and wherein the backdrill cavity is located in the first stub or the second stub.

11. The printed circuit board of any of claims 6 to 10, wherein the via is closed by a plated-over pad at an end of the via that is on an opposite side of the backdrill cavity prior to applying the fill material with the fill application pressure $P_A$ to the backdrill cavity.

12. The printed circuit board of any of claims 6 to 10, wherein the via is closed by a solder mask at an end of the via that is on an opposite side of the backdrill cavity prior to applying the fill material with the fill application pressure $P_A$ to the backdrill cavity.

13. A backdrill filling method, comprising:

setting, at a beginning of a backdrill filling process, a starting gas pressure in a backdrill cavity to a back-filling fixture chamber pressure in a filling pressure chamber, the backdrill cavity being in an unused portion of a via, wherein the via is connected to a signal trace in a printed circuit board, and the backdrill cavity depth is H; and applying a filling material with a fill application pressure to the backdrill cavity until a final gas pressure in the backdrill cavity equals to the fill application pressure and the backdrill cavity has a final gas volume proportional to (H-h), where *h* represents a penetration depth of the filling material within the backdrill cavity.

14. The backdrill filling method according to claim 13, wherein the non-conductive filling material comprises an epoxy.

15. The backdrill filling method according to claim 13 or claim 14, further comprising:
closing the via at an end of the via that is on an opposite side of the backdrill cavity prior to applying the fill material with the fill application pressure to the backdrill cavity.

INCIDENT SIGNAL

<u>1</u>

3

REFLECTED
SIGNAL

TRANSMITTED SIGNAL

5

6

## FIG. 1

FIG. 2

FIG. 3

FIG. 4

FIG. 5

FIG. 6B

FIG. 6A

RETURN LOSS OF VIA WITH 6 MIL STUB

WITH EPOXY FILL

WITH AIR FILL

MAGNITUDE (dB)

FREQ [GHz]

FIG. 7

EP 4 561 271 A1

800

801 — SET STARTING GAS PRESSURE IN BACKDRILL CAVITY TO BACK-FILLING FIXTURE CHAMBER PRESSURE IN FILLING PRESSURE CHAMBER, WITH BACK-FILLING FIXTURE CHAMBER PRESSURE SELECTED BASED ON DESIRED PENETRATION DEPTH OF NON-CONDUCTIVE FILLING MATERIAL WITHIN BACKDRILL CAVITY

803 — APPLY NON-CONDUCTIVE FILLING MATERIAL WITH FILL APPLICATION PRESSURE TO BACKDRILL CAVITY UNTIL FINAL GAS PRESSURE IN BACKDRILL CAVITY EQUALS TO FILL APPLICATION PRESSURE AND BACKDRILL CAVITY REACHES FINAL GAS VOLUME

FIG. 8

**EUROPEAN SEARCH REPORT**

Application Number

EP 24 21 4762

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2009/188710 A1 (SENK DAVID D [US]) 30 July 2009 (2009-07-30) * paragraphs [0022], [0034], [0036] - [0037], [0039]; figures 1-2B * | 1-15 | INV. H05K1/02 H05K3/00 |
| A | US 2003/000084 A1 (BOURRIERES FRANCIS [FR] ET AL) 2 January 2003 (2003-01-02) * paragraph [0002]; claims 4, 6, 9; figure 1 * | 1-15 | ADD. H05K1/11 |
| A | US 2014/093643 A1 (LI HAIYING [US]) 3 April 2014 (2014-04-03) * paragraphs [0002], [0026], [0031]; claims 1-6; figures 1, 3 * | 1-15 | |
| A | EP 2 421 343 A1 (MASS GMBH [DE]) 22 February 2012 (2012-02-22) * paragraphs [0005], [0011], [0017] - [0019]; claims 13-14, 16-17; figures 3-4 * | 1-15 | |

TECHNICAL FIELDS SEARCHED (IPC)

H05K

The present search report has been drawn up for all claims

| Place of search | Date of completion of the search | Examiner |
|---|---|---|
| The Hague | 20 March 2025 | Engel, Lukas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 21 4762

This annex lists the patent family members relating to the patent documents cited in the above-mentioned European search report.
The members are as contained in the European Patent Office EDP file on
The European Patent Office is in no way liable for these particulars which are merely given for the purpose of information.

20-03-2025

| Patent document cited in search report | Publication date | Patent family member(s) | | Publication date |
|---|---|---|---|---|
| US 2009188710 A1 | 30-07-2009 | NONE | | |
| US 2003000084 A1 | 02-01-2003 | AT | E242062 T1 | 15-06-2003 |
| | | AU | 2855701 A | 16-07-2001 |
| | | EP | 1244523 A1 | 02-10-2002 |
| | | FR | 2803228 A1 | 06-07-2001 |
| | | US | 2003000084 A1 | 02-01-2003 |
| | | WO | 0149422 A1 | 12-07-2001 |
| US 2014093643 A1 | 03-04-2014 | NONE | | |
| EP 2421343 A1 | 22-02-2012 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 63602273